# EUROPEAN PATENT APPLICATION

(11) **EP 0 791 957 A2**
(43) Date of publication of application: **27.08.1997**
(21) Application number: 97102592.9
(22) Date of filing: 18.02.1997
(51) Int. Cl.: H01L 21/74, H01L 21/322

(54) **Semiconductor substrate and method of manufacturing the same**

(30) Priority: 23.02.1996 JP 36039/96
(71) Applicant: NEC CORPORATION, Tokyo (JP)
(72) Inventor: Iwasaki, Hiroyuki, Minato-ku, Tokyo (JP)
(74) Representative: Baronetzky, Klaus, Dipl.-Ing.

(57) **Abstract**

Disclosed is a method of manufacturing a semiconductor substrate, including the steps of selectively forming a mask on the surface of a silicon substrate doped with an impurity before or after an epitaxial layer is grown on the surface of the silicon substrate, and when the covalent radius of the impurity is smaller than that of silicon, selectively implanting an impurity having a covalent radius larger than that of silicon by using the mask, or when the covalent radius of the impurity is larger than that of silicon, selectively implanting an impurity having a covalent radius smaller than that of silicon. A semiconductor substrate obtained by this method is also disclosed.

## Description

### BACKGROUND OF THE INVENTION

### 1. FIELD OF THE INVENTION

The present invention relates to a semiconductor substrate and, more particularly, to a semiconductor substrate such as an epitaxial silicon substrate having a high gettering ability, and a method of manufacturing the same.

### 2. DESCRIPTION OF THE PRIOR ART

Most of epitaxial silicon substrates used in manufacturing current semiconductor devices have a structure in which an epitaxial layer having a high resistivity (5 Ωcm or more) is formed on a low-resistivity silicon substrate (1 Ωcm or less) heavily doped with an impurity (boron, phosphorus, or arsenic). The use of an epitaxial silicon substrate having such a structure realizes a semiconductor element highly resistant to an α-ray and a latch-up phenomenon and excellent in the breakdown voltage of an oxide film. However, considering the gettering effect, a silicon substrate which is not subjected to epitaxial growth and can use precipitation of oxygen atoms is superior to the epitaxial silicon substrate. This is because the gettering mechanism in the epitaxial silicon substrate depends on not an oxygen atom but a misfit dislocation which is formed near the interface of the epitaxial layer and the silicon substrate, and the misfit dislocation density is low in the epitaxial silicon substrate.

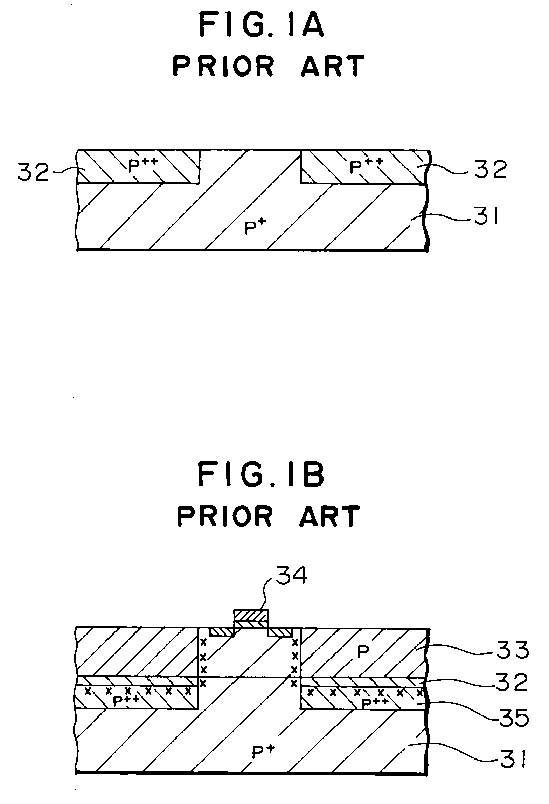

By, therefore, increasing the misfit dislocation density, the gettering ability in the epitaxial silicon substrate can be enhanced. As a means for this purpose, the following invention is proposed. That is, a low-resistivity silicon substrate is selectively, more heavily doped with the same impurity as that of the substrate to form a heavily doped impurity layer. Thereafter, epitaxial growth is performed to three-dimensionally form misfit dislocations and increase the density, thereby enhancing the gettering ability. For example, in Japanese Unexamined Patent Publication No. 3-34326, ions are selectively implanted in a p⁺-type silicon substrate 31 to form heavily doped p⁺-type layers 32, as shown in Fig. 1A. Then, as shown in Fig. 1B, epitaxial layers 33 are grown on the surface of the p⁺-type silicon substrate 31, and an element, e.g., a MOS element 34 in this case, is formed on the major surface of the epitaxial layer 33. As a result, misfit dislocations 35 are formed near the interface of each epitaxial layer 33 and the p⁺-type silicon substrate 31.

The first problem of the above-described prior art is that misfit dislocations are difficult to form at a high density and a high gettering ability cannot be obtained because the same impurity as that in the silicon substrate is doped in the silicon substrate. This is because a misfit dislocation is caused by a lattice distortion due to a difference between the lattice constants of the epitaxial layer and the silicon substrate. When impurities doped in the epitaxial layer and the silicon substrate are the same, i.e., the covalent radii are the same, misfit dislocations cannot be formed at a high density unless a large concentration difference is set.

The second problem is that the device performance such as the latch-up resistance is greatly influenced by a layer of an impurity which is selectively doped in the surface layer of the silicon substrate and has a resistivity different from that of a remaining region, and an optimum impurity concentration must be set in consideration of both the gettering ability and the latch-up resistance, resulting in a complicated device design. This is because the latch-up resistance in the epitaxial silicon substrate is strongly correlated to the resistivities of the epitaxial layer and the silicon substrate, and if the resistivity of the surface layer of the silicon substrate changes, the latch-up resistance also changes.

### SUMMARY OF THE INVENTION

The present invention has been made in consideration of the above situation, and has as its object to provide an epitaxial semiconductor substrate which has a high gettering ability by increasing the misfit dislocation density near the interface of an epitaxial layer and a silicon substrate without changing the resistivity of the surface layer of the silicon substrate, and has a high latch-up resistance, and a method of manufacturing the same.

To achieve the above object, according to the basic aspect of a semiconductor substrate in the present invention, there is provided an epitaxial silicon semiconductor substrate prepared by forming an epitaxial layer on a surface of a silicon substrate, wherein, when a covalent radius of an impurity in the silicon substrate is smaller than that of silicon, an impurity having a covalent radius larger than that of silicon is selectively doped in an interface of the silicon substrate and the epitaxial layer, or when the covalent radius of the impurity in the silicon substrate is larger than that of silicon, an impurity having a covalent radius smaller than that of silicon is doped.

In addition, to achieve the above object, according to the basic aspect of a method of manufacturing a semiconductor substrate in the present invention, there is provided a method of manufacturing a semiconductor substrate, including the steps of selectively forming a mask on a surface of a silicon substrate doped with an impurity before or after an epitaxial layer is grown on the surface of the silicon substrate, and when a covalent radius of the impurity is smaller than that of silicon, selectively implanting an impurity having a covalent radius larger than that of silicon by using the mask, or when the covalent radius of the impurity is larger than that of silicon, selectively implanting an impurity having a covalent radius smaller than that of silicon.

In this manner, an impurity having a covalent radius quite reverse in size relationship to the covalent radius of an impurity for silicon is made to exist on the interface of a silicon substrate and an epitaxial layer. With this structure, a lattice distortion which acts on the interface of the epitaxial layer and the silicon substrate can be increased to cause misfit dislocations at a high density in a region doped with the impurity, thereby enhancing the gettering ability. At the same time, the latch-up resistance is increased. That is, in the present invention, since an element which will serve as a carrier in the silicon substrate is not used as a dopant for causing misfit dislocations at a high density, the latch-up resistance is increased, thereby improving the reliability of the semiconductor element.

The above and many other advantages, features and additional objects of the present invention will become manifest to those versed in the art upon making reference to the following detailed description and accompanying drawings in which preferred embodiments incorporating the principles of the present invention are shown by way of illustrative example.

### BRIEF DESCRIPTION OF THE DRAWINGS

Figs. 1A and 1B are sectional views, respectively, showing a conventional semiconductor substrate and the steps in manufacturing the same;
Figs. 2A to 2C are sectional views, respectively, showing manufacturing steps according to the first embodiment of the present invention; and
Figs. 3A to 3C are sectional views, respectively, showing manufacturing steps according to the second embodiment of the present invention.

### DETAILED DESCRIPTION OF PREFERRED EMBODIMENTS

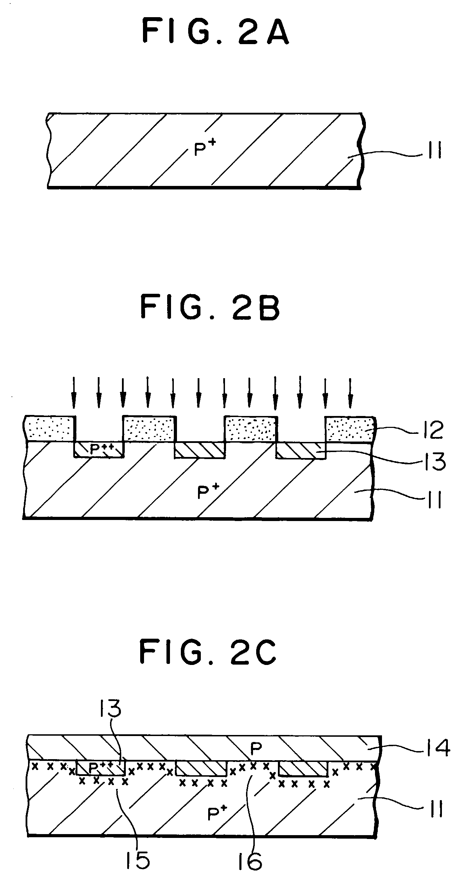

Preferred embodiments of the present invention will be described below with reference to the accompanying drawings. Figs. 2A to 2C are sectional views, respectively, showing manufacturing steps according to the first embodiment of the present invention. This embodiment exemplifies a case wherein the present invention is applied to a p/p⁺-type epitaxial silicon substrate. First of all, a resist film 12 is selectively formed by lithography on a p⁺-type silicon substrate 11 having a resistivity of 0.01 Ωcm like the one shown in Fig. 2A. The resist film 12 is formed in a region where, e.g., an element is to be formed. Next, as shown in Fig. 2B, germanium ions are implanted in the p⁺-type silicon substrate 11 using the resist film 12 as a mask under the conditions of 50 keV and 5E14 cm⁻².

Upon performing ion implantation under these conditions, the surface of the p⁺-type silicon substrate 11 immediately below the resist film 12 is not implanted with germanium ions and is kept unchanged because the resist film 12 serves a mask in ion implantation. On the other hand, in regions where no resist film 12 is formed, implanted layers 13 heavily implanted with germanium ions are formed. Since the covalent radius of a germanium atom is larger (1.22 Å) than that of a boron atom (0.88 Å) or a silicon atom (1.17 Å) as a p-type impurity, the lattice distortion of the germanium ion-implanted layer 13 is larger than that in a region not implanted with ions. For this reason, the density of misfit dislocations caused by the lattice distortion becomes high.

Thereafter, as shown in Fig. 2C, epitaxial growth is performed on the surface of the p⁺-type silicon substrate 11 to form a p-type epitaxial layer 14. The epitaxial growth at this time is performed by atmospheric pressure CVD at a growth temperature of 1,150°C with a gas mixture of hydrogen, silicon tetrachloride, and diborane as a source gas. Upon performing epitaxial growth in this manner, misfit dislocations are caused as shown in Fig. 2C. In the germanium ion-implanted region, misfit dislocations 15 are formed at a high density in the direction of depth and lateral direction of the silicon substrate. In the region not implanted with germanium ion, misfit dislocations 16 are formed in only the lateral direction of the silicon substrate. Note that lattice defects caused in implanting germanium ions are recovered by this epitaxial growth process at a high temperature (1,150°C).

In this manner, by doping germanium having a covalent radius larger than that of boron in the silicon substrate, the misfit dislocations 15 and 16 are formed at a high density on the interface of the epitaxial layer 14 and the silicon substrate 11 due to a large lattice distortion, resulting in a high gettering ability. In this case, an impurity different from an impurity doped in the silicon substrate 11, i.e., an impurity which will serve as a carrier in the silicon substrate 11 is not used as an impurity for forming misfit dislocations. Therefore, the latch-up resistance is increased to improve the reliability of the semiconductor element.

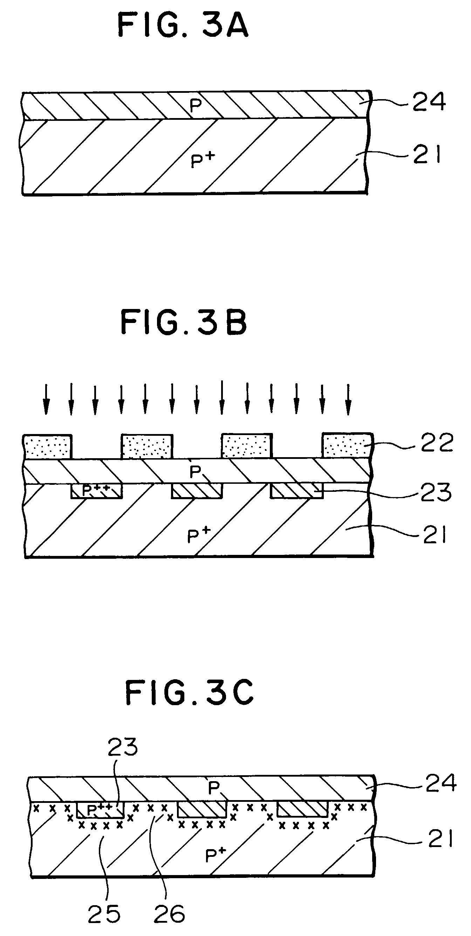

Figs. 3A to 3C are sectional views, respectively, showing manufacturing steps according to the second embodiment of the present invention. In this embodiment, after epitaxial growth is performed on a silicon substrate 21, germanium ions are implanted to form impurity layers of germanium ions in the surface portion of the silicon substrate, and to cause misfit dislocations at a high density. First of all, as shown in Fig. 2A, epitaxial growth is performed on the surface of a silicon substrate 21 to form a p/p⁺-type epitaxial silicon substrate having a p-type silicon epitaxial layer 24. Then, as shown in Fig. 2B, a resist film 22 is selectively formed using lithography on the p/p⁺-type epitaxial silicon substrate. In this state, germanium ions are implanted at a dose of 5 × 10¹⁴ atoms/cc such that the concentration peak appears near the interface of the epitaxial layer 24 and the silicon substrate 21, thereby forming germanium ion-implanted layers 23.

To recover lattice defects caused by ion implantation, annealing is performed in the N₂ gas atmosphere at 900°C for 30 minutes. By performing this annealing, misfit dislocations 25 and 26 are respectively formed at a high density in the regions of the germanium ion-implanted layers 23 and regions not implanted with ions, as shown in Fig. 3C.

Note that each embodiment uses germanium as an impurity for causing misfit dislocations, but another element may be used. In addition, each embodiment exemplifies the case wherein the covalent radius of boron in the silicon substrate is smaller than that of silicon in order to cause a lattice distortion. However, when the covalent radius of an impurity in the silicon substrate is larger than that of silicon, an impurity having a covalent radius smaller than that of silicon may be doped in the interface of the epitaxial layer and the silicon substrate.

## Claims

1. An epitaxial silicon semiconductor substrate prepared by forming an epitaxial layer on a surface of a silicon substrate, wherein, when a covalent radius of an impurity in said silicon substrate is smaller than that of silicon, an impurity having a covalent radius larger than that of silicon is selectively doped in an interface of said silicon substrate and said epitaxial layer.

2. An epitaxial silicon semiconductor substrate prepared by forming an epitaxial layer on a surface of a silicon substrate, wherein, when a covalent radius of an impurity in said silicon substrate is larger than that of silicon, an impurity having a covalent radius smaller than that of silicon is selectively doped in an interface of said silicon substrate and said epitaxial layer.

3. A substrate according to claim 1, wherein germanium is selectively implanted in a silicon substrate doped with boron as an impurity, and an epitaxial layer doped with boron as an impurity is grown on a surface of said silicon substrate.

4. A substrate according to claim 2, wherein germanium is selectively implanted in a silicon substrate doped with boron as an impurity, and an epitaxial layer doped with boron as an impurity is grown on a surface of said silicon substrate.

5. A method of manufacturing a semiconductor substrate, comprising the steps of: selectively forming a mask on a surface of a silicon substrate doped with an impurity; when a covalent radius of the impurity is smaller than that of silicon, implanting an impurity having a covalent radius larger than that of silicon in said silicon substrate by using said mask, or when the covalent radius of the impurity is larger than that of silicon, implanting an impurity having a covalent radius smaller than that of silicon in said silicon substrate by using said mask; and growing an epitaxial layer on said surface of said silicon substrate after removing said mask.

6. A method of manufacturing a semiconductor substrate, comprising the steps of: growing an epitaxial layer on a surface of a silicon substrate doped with an impurity; selectively forming a mask on a surface of said epitaxial layer; and when a covalent radius of the impurity is smaller than that of silicon, implanting an impurity having a covalent radius larger than that of silicon in an interface of said silicon substrate and said epitaxial layer by using said mask, or when the covalent radius of the impurity is larger than that of silicon, implanting an impurity having a covalent radius smaller than that of silicon in the interface by using said mask.
